# EUROPEAN PATENT APPLICATION

(11) **EP 2 669 347 A1**
(43) Date of publication of application: **04.12.2013**
(21) Application number: 12738904.7
(22) Date of filing: 11.01.2012
(51) Int. Cl.: C09J 163/00, C09J 9/02, C09J 11/04, C09J 11/06, H01B 1/22, H01L 31/042

(54) **ELECTRICALLY CONDUCTIVE ADHESIVE COMPOSITION, CONNECTOR AND SOLAR CELL MODULE**

(30) Priority: 27.01.2011 JP 2011015630
(71) Applicant: Hitachi Chemical Company, Ltd., Chiyoda-ku Tokyo 100-6606 (JP)
(72) Inventor: SUKATA Shinichirou, Tsukuba-shi Ibaraki 300-4247 (JP); HAYASHI Hiroki, Tsukuba-shi Ibaraki 300-4247 (JP); MOMOZAKI Aya, Tsukuba-shi Ibaraki 300-4247 (JP)
(74) Representative: Albrecht, Thomas
(86) International application number: PCT/JP2012/050374
(87) International publication number: WO 2012/102079

(57) **Abstract**

Provided is an electrically conductive adhesive composition including: electrically conductive particles (A) containing metal having a melting point of equal to or lower than 220°C; a thermosetting resin (B); a flux activator (C); and a curing catalyst (D), in which a reaction start temperature of the thermosetting resin (B) and the curing catalyst (D) is 130 to 200°C.

## Description

### Technical Field

The present invention relates to an electrically adhesive composition, and a connected body and a solar cell module using the same.

### Background Art

As means for solving aggravated global warming or fossil energy depletion, attention is paid on a solar cell which is a power generating system using sunlight. A structure in which solar battery cells in which an electrode is formed on a monocrystalline or polycrystalline Si wafer, are connected in series or in parallel to each other via a wiring member, has been employed for the current main solar battery cells.

For connection of the electrodes of the solar battery cell and the wiring member, it has been proposed to use an electrically conductive adhesive composition (for example, see Patent Literature 1). The electrically conductive adhesive composition of Patent Literature 1 is a composition obtained by mixing and dispersing of metal particles which are typified by silver particles in a thermosetting resin, and the electrical connection is mainly expressed by physical contact with these metal particles to the electrodes of the solar battery cells and the wiring member.

### Citation List

### Patent Literature

[Patent Literature 1] Japanese Unexamined Patent Application Publication No. 2005-243935

### Summary of Invention

### Technical Problem

However, in a case of using the electrically conductive adhesive composition of Patent Literature 1 or the like for the connection of the electrodes of the solar battery cells and the wiring member, when exposed under an atmosphere of a high temperature and high humidity, a connection property tends to be degraded.

Here, an object of the present invention is to provide an electrically conductive adhesive composition which has excellent conductivity, sufficiently suppresses decrease of the conductivity even after a high temperature and high humidity test (85°C/85%), and impart an excellent connection property, in a case of being used for the connection of the electrodes of the solar battery cells and the wiring member.

In addition, another object of the present invention is to provide a connected body and a solar cell module using the electrically conductive adhesive composition.

### Solution to Problem

According to the present invention, there is provided an electrically conductive adhesive composition including: electrically conductive particles (A) containing metal having a melting point of equal to or lower than 220°C (hereinafter, also referred to as "electrically conductive particles (A)"); a thermosetting resin (B); a flux activator (C); and a curing catalyst (D), in which a reaction start temperature of the thermosetting resin (B) and the curing catalyst (D) is 130 to 200°C. According to such an electrically conductive adhesive composition, by using the configuration described above, in a case of using the composition for the connection of electrodes of solar battery cells and wiring members, excellent conductivity is obtained, and decrease of the conductivity is sufficiently suppressed even after a high temperature and high humidity test (85°C/85%).

In addition, in the present specification, the "melting point" refers to a value measured by Differential Scanning Calorimetry (DSC), for example. Further, in the present specification, the "high temperature and high humidity test (85°C/85%)" refers to a test of exposing a subject under an atmosphere with a high temperature and high humidity of 85°C and 85%RH for 1500 hours, and "%RH" represents relative humidity.

It is preferable that the metal of the electrically conductive particles (A) contain at least one component selected from a group consisting of bismuth, indium, tin, and zinc. Accordingly, it is possible to decrease the melting point of the electrically conductive particles while maintaining excellent conductivity.

It is preferable that the thermosetting resin (B) contain an epoxy resin, from a viewpoint of obtaining excellent connection stability.

It is preferable that the flux activator (C) contain a compound having a hydroxy group and a carboxyl group.

The electrically conductive adhesive composition may be suitably used for electrical connection of the electrodes of solar battery cells and a wiring member.

In addition, according to the present invention, there is provided a connected body in which a plurality of solar battery cells are connected via a wiring member, in which electrodes of the solar battery cells and the wiring member are connected via the electrically conductive adhesive composition described above.

Further, according to the present invention, there is provided a method for producing a solar cell module including: a step of applying the electrically conductive adhesive composition described above onto electrodes of solar battery cells; a step of disposing the electrodes onto which the electrically conductive adhesive composition is applied and a wiring member so as to face to each other; a step of laminating a sealing member and a light transmission member in this order onto a light-receiving surface of the solar battery cell; a step of laminating a sealing member and a protection member in this order onto a surface on an opposite side to the light-receiving surface of the solar battery cell; and a step of sealing the solar battery cells while electrically connecting and adhering the solar battery cells and the wiring members by heating the obtained laminated body.

Furthermore, according to the present invention, there is provided a solar cell module in which electrodes of a plurality of solar battery cells and a wiring member are electrically connected to each other via the electrically conductive adhesive composition described above.

### Advantageous Effects of Invention

According to the present invention, it is possible to provide an electrically conductive adhesive composition which has excellent conductivity and sufficiently suppresses decrease of the conductivity even after the high temperature and high humidity test (85°C/85%), in a case of being used for the connection of the electrodes of the solar battery cells and the wiring member. In addition, by using the electrically conductive adhesive composition of the present invention, it is easier to collectively perform the connection of, and adhering of the solar battery cells and the wiring members and the sealing of the solar battery cells, and compared to a conventional producing step of a solar cell module, it is possible to realize low cost by shortening of steps and improvement of productivity.

### Brief Description of Drawing

Fig. 1 is a schematic view of a DSC chart to show a reaction start temperature of a thermosetting resin (B) and a curing catalyst (D).
Fig. 2 is a schematic view showing main parts of a solar cell module according to the present invention.
Fig. 3 is a view for illustrating one embodiment of a method for producing a solar cell module according to the present invention.
Fig. 4 is a view showing pictures obtained by observing fusion states of metal in an electrically conductive adhesive composition between surface electrodes of a solar cell module and a wiring member using an X-ray inspection system.

### Description of Embodiments

Hereinafter, the preferred embodiments of the present invention will be described in detail with reference to the drawings. In addition, in the drawings, the same reference numerals are given to the same or corresponding parts, and the overlapping description is omitted.

An electrically conductive adhesive composition of the present invention contains electrically conductive particles (A), a thermosetting resin (B), a flux activator (C), and a curing catalyst (D).

As the electrically conductive particles (A), particles which contains metal having a melting point of equal to or lower than 220°C, more preferably particles which contains metal having a melting point of equal to or lower than 180°C, and even more preferably particles which contains metal having a melting point of equal to or lower than 150°C can be used. The lower limit of the melting point of the metal of the electrically conductive particles (A) is not particularly limited, however, it is about 100°C. If such electrically conductive particles are used for the electrically conductive adhesive composition, it is considered that the electrically conductive particles are melted and fused, that is, a plurality of melted electrically conductive particles (A) are assembled for integration, and the integrated fused body electrically connects target objects directly.

In consideration of environmental friendliness, the metal of the electrically conductive particles (A) is preferably configured from metal other than lead. An example of such metal includes a simple substance containing at least one kind of component selected from tin (Sn), bismuth (Bi), indium (In), and zinc (Zn) or alloy. In addition, from a viewpoint of obtaining even more excellent connection reliability, the alloy can contain high-melting-point components selected from platinum (Pt), gold (Au), silver (Ag), copper (Cu), nickel (Ni), palladium (Pd), aluminum (Al), and the like, in a range where the melting point of the entire metal of the electrically conductive particles (A) is equal to or lower than 220°C.

In detail, as the metal configuring the electrically conductive particles (A), Sn42-Bi58 solder (melting point of 138°C), Sn48-In52 solder (melting point of 117°C), Sn42-Bi57-Ag1 solder (melting point of 139°C), Sn90-Ag2-Cu0.5-Bi7.5 solder (melting point of 189°C), Sn96-Zn8-Bi3 solder (melting point of 190°C), Sn91-Zn9 solder (melting point of 197°C), and the like are preferable since they show a clear solidification behavior after melting. The solidification behavior is a behavior of the metal being cooled and solidified again after being melted. Among these, from a view point of availability or a low melting point, Sn-42-Bi58 solder is preferably used. Those are used alone as one kind, or in combination of two or more kinds.

An average particle size of the electrically conductive particles (A) is not particularly limited, however, is preferably 0.1 µm to 100 µm. If the average particle size thereof is less than 0.1 µm, the viscosity of the electrically conductive adhesive composition tends to be increased, and the workability tends to be decreased. In addition, if the average particle size of the electrically conductive particles exceeds 100 µm, printing performance and connection reliability tend to be degraded. From a viewpoint of obtaining even more excellent printing performance and workability of the electrically conductive adhesive composition, the average particle size thereof is more preferably 1 to 50 µm. In particular, from a viewpoint of further improving preservation stability of the electrically conductive adhesive composition and mounting reliability of a cured product, the average particle size thereof is particularly preferably 5 to 30 µm. Herein, the average particle size is a value measured by a laser diffraction and scattering method (Kamioka Mining Test Method No. 2).

In addition to the particles configured with only the metal having the melting point of equal to or lower than 220°C, the electrically conductive particles (A) may be electrically conductive particles obtained by coating surfaces of particles consisting of solid-state materials other than metal such as ceramics, silica, and resin materials, with a metal film consisting of metal having a melting point of equal to or lower than 220°C, or may be a mixture thereof. Examples of such electrically conductive particles include resin core solder ball.

The content of the electrically conductive particles (A) of the electrically conductive adhesive composition is preferably 5 to 95% by mass with respect to the total amount of the electrically conductive adhesive composition. In a case where the content of the metal is less than 5% by mass, the conductivity of the cured product of the electrically conductive adhesive composition tends to be degraded. If the content thereof exceeds 95% by mass, the viscosity of the electrically conductive adhesive composition is increased and the workability tends to be decreased, and in addition, since the adhesive components in the electrically conductive adhesive composition are relatively decreased, the mounting reliability of the cured product tends to be decreased.

From a viewpoint of improving the workability or conductivity, the content of the electrically conductive particles (A) is more preferably 10 to 90% by mass with respect to the total amount of the electrically conductive adhesive composition, and from a viewpoint of improving the mounting reliability of the cured product, the content thereof is even more preferably 15 to 85% by mass, and particularly preferably 50 to 85% by mass.

In addition, electrically conductive particles (a1) consisting of metal having a melting point of higher than 220°C may be used with the electrically conductive particles (A). An example of such metal having a melting point of higher than 220°C includes a simple substance or alloy containing at least one kind of component selected from Pt, Au, Ag, Cu, Ni, Pd, Al, and the like, and more specifically, the examples thereof include Au powder, Ag powder, Cu powder, Ag-plated Cu powder. As a commercially available product, "MA05K" (product name, manufactured by Hitachi Chemical Co., Ltd.) which is silver-plated copper powder can be purchased.

In a case of using the electrically conductive particles (a1) consisting of metal having the melting point of higher than 220°C with the electrically conductive particles (A), a combination ratio thereof is preferably in a range where (A) : (a1) is 99:1 to 50:50 by mass ratio, and more preferably in a range where (A) : (a1) is 99:1 to 60:40.

The thermosetting resin (B) performs an action of adhering an adherend, and an action of alleviating stress applied to the adherend. The adherend is not particularly limited, however, in a solar cell module, examples thereof include a wiring member and electrodes. Examples of such a thermosetting resin include a thermosetting organic polymer compound such as an epoxy resin, a (meth)acrylic resin, a maleimide resin, and a cyanate resin, and a precursor thereof. Herein, the (meth)acrylic resin denotes a methacrylic resin and an acrylic resin. Among these, a compound having polymerizable carbon-carbon double bond represented by the (meth)acrylic resin and the maleimide resin, or the epoxy resin is preferable. The thermosetting resins described above are excellent in heat resistance and the adhesiveness, and also, since the resins can be used in a liquid state if they are dissolved or dispersed in an organic solvent if necessary, they are also excellent in workability. In addition, from viewpoints of reliability and availability of a temperature cycle test (TCT), an epoxy resin is more preferably used. The thermosetting resin described above is used alone as one kind, or in combination of two or more kinds.

The epoxy resin is not particularly limited as long as it is a compound having two or more epoxy groups in one molecule thereof, and well-known compounds can be used. Examples of the epoxy resin include an epoxy resin and the like derived from bisphenol A, bisphenol F, bisphenol AD and the like and epichlorohydrin.

A commercially available product can be used for the epoxy resin. Specific examples thereof include AER-X8501 (product name, manufactured by Asahi Kasei Corporation), R-301 (product name, manufactured by Mitsubishi Chemical Corporation), and YL-980 (product name, manufactured by Mitsubishi Chemical Corporation) which are bisphenol A-type epoxy resins, YDF-170 (product name, manufactured by Tohto Kasei Co., Ltd.) and YL-983 (product name, manufactured by Mitsubishi Chemical Corporation) which are bisphenol F-type epoxy resins, R-1710 (product name, manufactured by Mitsui Chemicals Inc.) which is a bisphenol AD-type epoxy resin, N-730S (product name, manufactured by DIC Corporation) and Quatrex-2010 (product name, manufactured by The Dow Chemical Company) which are phenol novolac type epoxy resins, YDCN-702S (product name, manufactured by Tohto Kasei Co., Ltd.) and EOCN-100 (product name, manufactured by NIPPON KAYAKU Co., Ltd.) which are cresol novolac type epoxy resins, EPPN-501 (product name, manufactured by NIPPON KAYAKU Co., Ltd.), TACTIX-742 (product name, manufactured by The Dow Chemical Company), VG-3010 (product name, manufactured by Mitsui Chemicals Inc.), and 1032S (product name, manufactured by Mitsubishi Chemical Corporation) which are multifunctional epoxy resins, HP-4032 (product name, manufactured by DIC Corporation) which is an epoxy resin having a naphthalene skeleton, EHPE-3150 and CEL-3000 (product names, both manufactured by Daicel Corporation), DME-100 (product name, manufactured by New Japan Chemical Co., Ltd.), and EX-216L, (product name, manufactured by Nagase ChemteX Corporation) which are alicyclic epoxy resins, W-100 (product name, manufactured by New Japan Chemical Co., Ltd.) which is an aliphatic epoxy resin, ELM-100 (product name, manufactured by Sumitomo Chemical Co., Ltd.), YH-434L (product name, manufactured by Tohto Kasei Co., Ltd.), TETRAD-X and TETRAD-C (product names, both manufactured by Mitsubishi Gas Chemical Company), and 630 and 630LSD (product names, both manufactured by Japan Epoxy Resin Co., Ltd.) which are amine type epoxy compounds, DENACOL EX-201 (product name, manufactured by Nagase ChemteX Corporation) which is a resorcin type epoxy resin, DENACOL EX-211 (product name, manufactured by Nagase ChemteX Corporation) which is a neopentyl glycol type epoxy resin, DENACOL EX-212 (product name, manufactured by Nagase ChemteX Corporation) which is a hexanediol glycol type epoxy resin, DENACOL EX series (EX-810, 811, 850, 851, 821, 830, 832, 841, and 861 (product names, all manufactured by Nagase ChemteX Corporation)) which are ethylene-propylene glycol type epoxy resins, and E-XL-24, and E-XL-3L (product names, all manufactured by Mitsui Chemicals, Inc.) which are epoxy resins represented by the following general formula (I). Among these epoxy resins, the bisphenol A-type epoxy resin, the bisphenol F-type epoxy resin, the bisphenol AD-type epoxy resin, and the amine type epoxy resin having less ionic impurities and excellent reactivity are particularly preferable.

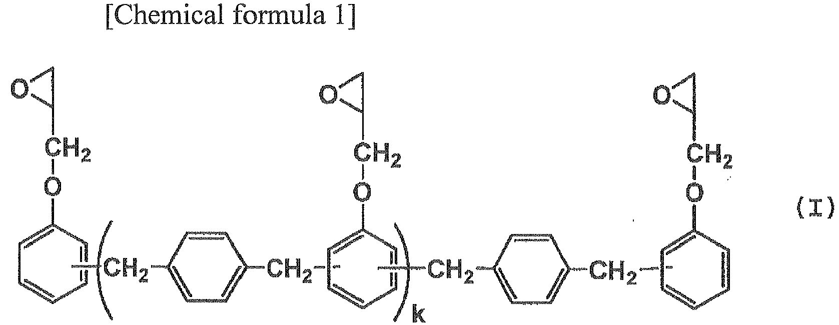

Herein, in Formula (I), k represents an integer from 1 to 5.

The epoxy resins described above are used alone as one kind, or in combination of two or more kinds.

In a case of containing the epoxy resin as the thermosetting resin (B), an epoxy compound having only one epoxy group in one molecular may be further contained as a reactive diluent. Such epoxy compounds are available as commercially available products, and specific examples thereof include PGE (product name, manufactured by NIPPON KAYAKU Co., Ltd.), PP-101 (product name, manufactured by Tohto Kasei Co., Ltd.), ED-502, ED-509, and ED-509S (product names, manufactured by ADEKA CORPORATION), YED-122 (product name, manufactured by Yuka Shell Epoxy Co., Ltd.), KBM-403 (product name, manufactured by Shin-Etsu Chemical Co., Ltd.), and TSL-8350, TSL-8355, and TSL-9905 (product names, manufactured by Toshiba Silicones Co., Ltd.). These are used alone as one kind or in combination of two or more kinds.

In a case of combining the reactive diluent to the electrically conductive adhesive composition, the combination rate may be in a range of not disturbing the effects of the present invention, and is preferably 0.1 to 30% by mass with respect to the total amount of the epoxy resins.

The (meth)acrylic resin is configured from the compound having polymerizable carbon-carbon double bond. Examples of the compound include a monoacrylate compound, a monomethacrylate compound, a diacrylate compound, and a dimethacrylate compound.

Examples of the monoacrylate compound include methyl acrylate, ethyl acrylate, propyl acrylate, isopropyl acrylate, n-butyl acrylate, isobutyl acrylate, t-butyl acrylate, amyl acrylate, isoamyl acrylate, hexyl acrylate, heptyl acrylate, octyl acrylate, 2-ethylhexyl acrylate, nonyl acrylate, decyl acrylate, isodecyl acrylate, lauryl acrylate, tridecyl acrylate, hexadecyl acrylate, stearyl acrylate, isostearyl acrylate, cyclohexyl acrylate, isobornyl acrylate, diethylene glycol acrylate, polyethylene glycol acrylate, polypropylene glycol acrylate, 2-methoxyethyl acrylate, 2-ethoxyethyl acrylate, 2-butoxyethyl acrylate, methoxy diethylene glycol acrylate, methoxy polyethylene glycol acrylate, dicyclopentenyloxyethyl acrylate, 2-phenoxyethyl acrylate, phenoxy diethylene glycol acrylate, phenoxy polyethylene glycol acrylate, 2-benzoyloxyethyl acrylate, 2-hydroxy-3-phenoxypropyl acrylate, benzyl acrylate, 2-cyanoethyl acrylate, γ-acryloxyethyl trimethoxysilane, glycidyl acrylate, tetrahydrofurfuryl acrylate, dimethylaminoethyl acrylate, diethylaminoethyl acrylate, acryloxyethyl phosphate, and acryloxyethylphenyl acid phosphate.

Examples of the monomethacrylate compound include methyl methacrylate, ethyl methacrylate, propyl methacrylate, isopropyl methacrylate, n-butyl methacrylate, isobutyl methacrylate, t-butyl methacrylate, amyl methacrylate, isoamyl methacrylate, hexyl methacrylate, heptyl methacrylate, octyl methacrylate, 2-ethylhexyl methacrylate, nonyl methacrylate, decyl methacrylate, iso-decyl methacrylate, lauryl methacrylate, tridecyl methacrylate, hexadecyl methacrylate, stearyl methacrylate, isostearyl methacrylate, cyclohexyl methacrylate, isobornyl methacrylate, diethylene glycol methacrylate, polyethylene glycol methacrylate, polypropylene glycol methacrylate, 2-methoxyethyl methacrylate, 2-ethoxyethyl methacrylate, 2-butoxyethyl methacrylate, methoxy diethylene glycol methacrylate, methoxy polyethylene glycol methacrylate, dicyclopentenyloxyethyl methacrylate, 2-phenoxyethyl methacrylate, phenoxydiethylene glycol methacrylate, phenoxypolyethylene glycol methacrylate, 2-benzoyloxyethyl methacrylate, 2-hydroxy-3-phenoxypropyl methacrylate, benzyl methacrylate, 2-cyanoethyl methacrylate, γ-methacryloxyethyl trimethoxysilane, glycidyl methacrylate, tetrahydrofurfuryl methacrylate, dimethylaminoethyl methacrylate, diethylaminoethyl methacrylate, methacryloxyethyl phosphate, and methacryloxyethylphenyl acid phosphate.

Examples of the diacrylate compound include ethylene glycol diacrylate, 1,4-butanediol diacrylate, 1,6-hexanediol diacrylate, 1,9-nonanediol diacrylate, 1,3-butanediol diacrylate, neopentyl glycol diacrylate, diethylene glycol diacrylate, triethylene glycol diacrylate, tetraethylene glycol diacrylate, polyethylene glycol diacrylate, tripropylene glycol diacrylate, polypropylene glycol diacrylate, a resultant of reaction between 1 mole of bisphenol A, bisphenol F, or bisphenol AD and 2 moles of glycidyl acrylate, diacrylate of a polyethylene oxide adduct of bisphenol A, bisphenol F, or bisphenol AD, diacrylate of a polypropylene oxide adduct of bisphenol A, bisphenol F, or bisphenol AD, bis(acryloxypropyl)polydimethylsiloxane, and a bis(acryloxypropyl)methylsiloxane-dimethylsiloxane copolymer.

Examples of the dimethacrylate compound include ethylene glycol dimethacrylate, 1,4-butanediol dimethacrylate, 1,6-hexanediol dimethacrylate, 1,9-nonanediol dimethacrylate, 1,3-butanediol dimethacrylate, neopentyl glycol dimethacrylate, diethylene glycol dimethacrylate, triethylene glycol dimethacrylate, tetraethylene glycol dimethacrylate, polyethylene glycol dimethacrylate, tripropylene glycol dimethacrylate, polypropylene glycol dimethacrylate, a resultant of reaction between 1 mole of bisphenol A, bisphenol F, or bisphenol AD, and 2 moles of glycidyl methacrylate, dimethacrylate of a polyethylene oxide adduct of bisphenol A, bisphenol F, or bisphenol AD, a polypropylene oxide adduct of bisphenol F or bisphenol AD, bis(methacryloxypropyl) polydimethylsiloxane, and a bis(methacryloxypropyl) methyl siloxane-dimethyl siloxane copolymer.

These compounds are used alone as one kind, or in combination of two or more kinds. In addition, when containing the (meth)acrylic resin as the thermosetting resin, these compound may be used after performing polymerization in advance, or the compounds may be mixed with the electrically conductive particles (A) and the flux activator (C) and polymerization may be performed at the same time as the mixing. A compound having carbon-carbon double bond which is polymerizable in such molecules is used alone as one kind, or in combination of two or more kinds. In a case of using a (meth)acrylic resin obtained by performing polymerization of the compound in advance, from a viewpoint of thermosetting, it is preferable to contain an epoxy group or a group having carbon-carbon double bond on a side chain of the (meth)acrylic resin.

A commercially available resin can be used for the (meth)acrylic resin. Specific Examples thereof include FINEDIC A-261 (product name, manufactured by DIC Corporation), FINEDIC A-229-30 (product name, manufactured by DIC Corporation), and the like which are (meth)acrylic resins having epoxy groups on a side chain.

The content of the thermosetting resin (B) of the electrically conductive adhesive composition is preferably 1 to 60% by mass, is more preferably 5 to 40% by mass, and is even more preferably 10 to 30% by mass, with respect to the total amount of the electrically conductive adhesive composition.

The flux activator (C) shows a function of removing an oxide film formed on the surfaces of the electrically conductive particles (A). By using such flux activator, the oxide film which is disturbance of melting and fusion of the electrically conductive particles (A) is removed. The flux activator (C) is not particularly limited as long as it is a compound which does not disturb a curing reaction of the thermosetting resin (B), and a well-known compound can be used.

Examples of the flux activator (C) include a rosin resin, a compound containing a carboxyl group, a phenolic hydroxy group, or an alcoholic hydroxy group in a molecule, dibasic acid having an alkyl group on a side chain such as 2,4-diethylglutaric acid, 2,2-diethylglutaric acid, 3-methylglutaric acid, 2-ethyl-3-propylglutaric acid, and 2,5-diethyladipic acid. Among them, since excellent flux activity is shown and excellent reactivity with the epoxy resin which can be used as the thermosetting resin (B) is shown, the compound containing a hydroxy group and a carboxyl group in a molecule is preferable and aliphatic dihydroxycarboxylic acid is particularly preferable. In detail, a compound represented by the following General Formula (V) or tartaric acid is preferable.

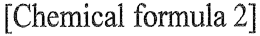

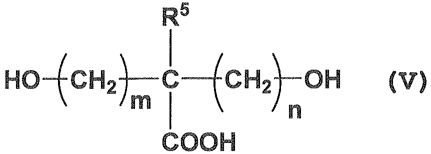

Herein, in Formula (V), R⁵ represents an alkyl group having 1 to 5 carbon atoms, and from a viewpoint of further efficiently exhibiting the effects by using the compound represented by General Formula (V), a methyl group, an ethyl group, or a propyl group is preferable. In addition, n and m independently represent an integer from 0 to 5, and from a viewpoint of further efficiently exhibiting the effects by using the compounds represented by General Formula (V), it is preferable that n be 0 and m be 1, or both n and m be 1.

Examples of the compound represented by General Formula (V) include 2,2-bis(hydroxymethyl)propionic acid, 2,2-bis(hydroxymethyl)butyric acid, and 2,2-bis(hydroxymethyl)pentanoic acid.

From a viewpoint of further efficiently exhibiting the effects of the present invention, the content of the flux activator (C) is preferably 0.5 to 20 parts by mass, and more preferably 0.5 to 15 parts by mass, with respect to 100 parts by mass of the total amount of the electrically conductive particles (A). Further, from viewpoints of the preservation stability and the conductivity, the content thereof is more preferably 1 to 10 parts by mass. In a case where the content of the flux activator is less than 0.5 parts by mass, a melting property of the metal of the electrically conductive particles (A) tends to be decreased, and the conductivity tends to be decreased, and in a case where the content thereof exceeds 20 parts by mass, the preservation stability and the printing property tend to be decreased.

The curing catalyst (D) has an effect of promoting curing of the thermosetting resin (B). In a case where the thermosetting resin (B) is the epoxy resin, the curing catalyst (D) is preferably an imidazole compound, from viewpoints of the desired curing property at a curing temperature, length of usage time, and heat resistance of a cured product. Examples of the commercially available products thereof include 2P4MHZ-PW (2-phenyl-4-methyl-5-hydroxymethylimidazole), 2PHZ-PW (2-phenyl-4,5-dihydroxymethylimidazole), C11Z-CNS (1-cyanoethyl-2-undecylimidazole), 2E4MZ-CN (1-cyanoethyl-2-ethyl-4methylimidazole), 2PZ-CN (1-cyanoethyl-2-phenylimidazole), 2MZ-A (2,4-diamino-6-[2'-methylimidazolyl-(1')]-ethyl-s-triazine), 2E4MZ-A (2,4-diamino-6-[2'-ethyl-4'-methylimidazolyl-(1')]-ethyl-s-triazine), 2MAOK-PW (2,4-diamino-6- [2'-methylimidazolyl-(1')]-ethyl-s-triazine isocyanuric acid adduct) (product names, all manufactured by Shikoku Chemicals Corporation) which are imidazole compounds. The curing catalysts are used alone as one kind, or in combination of two or more kinds.

In a case where the thermosetting resin (B) is the (meth)acrylic resin, examples of the curing catalyst (D) include a radical polymerization initiator. From a viewpoint of efficiently suppressing voids, organic peroxide is suitable for the radical polymerization initiator. In addition, from a viewpoint of improving the curing property and viscosity stability of the electrically conductive adhesive composition, a decomposition temperature of the organic peroxide is preferably 130 to 200°C.

A radical polymerization initiator which is normally used can be used for the radical polymerization initiator, and examples thereof include peroxide such as benzoyl peroxide or t-butylperoxy-2-ethylhexanoate, an azo compound such as azobisisobutyronitrile or azobisdimethylvaleronitrile, and the like.

The content of the curing catalyst (D) is preferably 0.01 parts by mass to 90 parts by mass and more preferably 0.1 to 50 parts by mass, with respect to 100 parts by mass of the epoxy resin. If the content of this curing catalyst (D) is less than 0.01 parts by mass, the curing property tends to be decreased, and if the content thereof exceeds 90 parts by mass, the viscosity is increased, and the workability when handling the electrically conductive adhesive composition tends to be degraded.

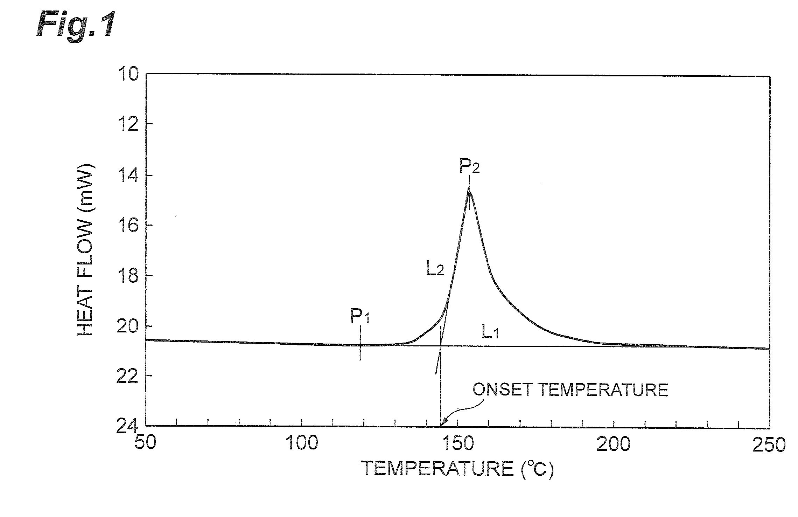

The reaction start temperature of the thermosetting resin (B) and the curing catalyst (D) is 130 to 200°C. The reaction start temperature of the thermosetting resin (B) and the curing catalyst (D) denotes a temperature at which curing exothermic reaction starts when the thermosetting resin (B) and the curing catalyst (D) are combined with the same combination ratio as the combination ratio of the electrically conductive adhesive composition without using the solvent, and temperature rising is measured by the DSC measurement. In a case of performing temperature rising measurement under a nitrogen atmosphere at a temperature rising rate of 10°C/min from 30°C to 250°C using a enclosed container for DSC, a DSC chart shown in Fig. 1 is obtained. A rising temperature of the exothermic peak (DSC Onset temperature) is acquired from the obtained DSC chart, and this is set as the reaction start temperature. Herein, a temperature which corresponds to an intersection point of an extended line of a base line (L1) which passes through a point (P1) at which the exothermic peak of the DSC chart starts to rise, and a tangent line (L2) with respect to an inflection point of the DSC curve between the point (P1) at which the exothermic peak starts to rise and a exothermic peak point (P2) is set as the onset temperature.

In addition, the reaction start temperature of the thermosetting resin (B) and the curing catalyst (D) is 130 to 200°C, more preferably 140 to 190°C, and even more preferably 140 to 180C. If this reaction start temperature is less than 130°C, the melting and the fusion of the electrically conductive particles (A) tends to be disturbed. Particularly, in a case where the time to reach the set temperature in the heating step at the time of producing the solar cell module is delayed, if the reaction start temperature is less than 130°C, since the curing of the thermosetting resin proceeds before the occurrence of melting and fusion of the metal of the electrically conductive particles (A), melting and fusion of the electrically conductive particles are disturbed. On the other hand, if the reaction start temperature exceeds 200°C, the curing property of the thermosetting resin at the time of the heating is degraded, and the time for completely curing the thermosetting resin is significantly increased. In a case where the thermosetting resin is not completely cured, there is a possibility of a problem that the adhering strength with the adherend is decreased.

In addition to the respective components described above, the electrically conductive adhesive composition may contain one kind or more additives selected from a group consisting of a flexibility imparting agent for reaction alleviation, diluents for improving the workability, an adhesiveness improving agent, a wettability improving agent, and defoamer. In addition to these components, various additives may be contained in a range of not disturbing the effects of the present invention.

In order to improve the adhesiveness, the electrically conductive adhesive composition may contain a coupling agent such as a silane coupling agent or a titanium coupling agent. Examples of the silane coupling agent include "KBM-573" which is a product name manufactured by Shin-Etsu Chemical Co., Ltd. In addition, in order to improve wettability, an anionic surfactant or fluorine surfactant may be contained in the electrically conductive adhesive composition. Further, the electrically conductive adhesive composition may contain silicone oil or the like as a defoamer. The additives described above are used alone as one kind or in combination of two or more kinds. In a case of containing these, 0.1 to 10% by mass of these is preferably contained with respect to the total amounts of the electrically conductive adhesive composition.

Examples of the flexibility imparting agent include liquid polybutadiene ("CTBN-1300X31" and "CTBN-1300X9", product names all manufactured by Ube industries, Ltd., and "NISSO-PB-C-2000", product name manufactured by Nippon Soda Co., Ltd."). In a case of containing the flexibility imparting agent, the content thereof is suitably 0.1 to 500 parts by mass, with respect to 100 parts by mass of the total amount of the thermosetting resin (B).

In addition, in order to have even more excellent workability at the time of manufacturing a paste composition and the coating workability at the time of using it, organic solvents can be added to the electrically conductive adhesive composition, if necessary. As such organic solvents, organic solvents having a relatively high boiling point such as butylcellosolve, carbitol, butylcellosolve acetate, carbitol acetate, dipropylene glycol monomethyl ether, ethylene glycol diethyl ether, α-terpineol, and the like are preferable. In a case of containing the organic solvents, the content thereof is preferably 0.1 to 30% by mass with respect to the total amounts of the electrically conductive adhesive composition.

The electrically conductive adhesive composition may contain a filler. Examples of the filler include polymer particles such as acrylic rubber or polystyrene, and inorganic particles such as diamond, boron nitride, aluminum nitride, alumina, and silica. These fillers may be used alone as one kind or in combination or two or more kinds.

In a case where the epoxy resin is used as the thermosetting resin (B), the electrically conductive adhesive composition of the embodiment may further contain a curing agent, however, it is practically not preferable to contain the curing agent, from viewpoints of preservation stability and curing time. The "practically" means to contain the curing agent to be equal to or less than 0.5% by mass with respect to the total amounts of the electrically conductive adhesive composition.

The curing agent is a compound having a functional group which reacts with the epoxy group of the epoxy resin, and examples thereof include H-1 (product name, manufactured by Meiwa Plastic Industries, Ltd.) and VR-9300 (product name, manufactured by Mitsui Toatsu Chemicals, Inc.) which are phenol novolac resins, XL-225 (product name, manufactured by Mitsui Toatsu Chemicals, Inc.) which is a phenol aralkyl resin, MTPC (product name, manufactured by Honshu Chemical Industry Co., Ltd.) which is p-cresol novolac resin represented by the following General Formula (II), AL-VR-9300 (product name, manufactured by Mitsui Toatsu Chemicals, Inc.) which is an allylated phenol novolac resin, PP-700-300 (product name, manufactured by Nippon Petrochemicals Co., Ltd.) which is a special phenol resin represented by the following General Formula (III), ADH, PDH, and SDH (product names, all manufactured by Japan Finechem Company, Inc.) which are dibasic acid dihydrazide represented by the following General Formula (IV), and NOVACURE (product name, manufactured by Asahi Kasei Corporation) which is a microcapsule type curing agent consisting of a resultant of reaction between of epoxy resins and amine compounds.

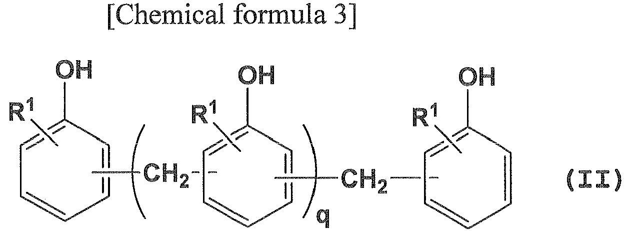

In Formula (II), R¹ independently represents a monovalent hydrocarbon group, preferably, a methyl group or an allyl group, and q represents an integer from 1 to 5.

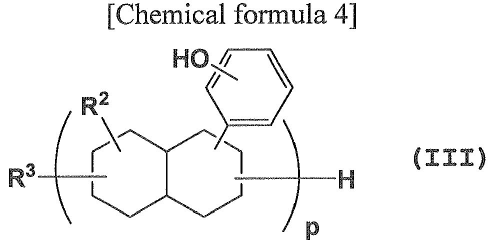

In Formula (III), R² represents an alkyl group, preferably a methyl group or an ethyl group, R³ represents a hydrogen atom or a monovalent hydrocarbon group, and p represents an integer from 2 to 4.

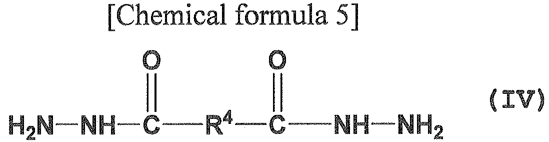

In Formula (IV), R⁴ represents divalent aromatic group or a linear or branched alkylene group having 1 to 12 carbon atoms, preferably a m-phenylene group or a p-phenylene group.

In the electrically conductive adhesive composition of the embodiment, from a viewpoint of more efficiently exhibiting the effects, the combination ratio of the component other than the electrically conductive particles (A) (hereinafter, referred to as "adhesive component") with respect to the electrically conductive particles (A) (adhesive component / electrically conductive particles) is preferably 5/95 to 50/50, with respect to the solid content ratio (mass ratio) in the electrically conductive adhesive composition. Further, from viewpoints of adhesiveness, conductivity, and workability, the combination ratio is more preferably 10/90 to 30/70. If this combination ratio is less than 5/95, the viscosity of the adhesive composition is increased and thus, the workability is difficult to be secured, or the adhesiveness tends to be decreased. If this combination ratio is lower than 50/50, the conductivity tends to be decreased.

In the present embodiment, any of the exemplified respective components described above may be combined to each other.

By performing mixing, dissolving, kneading or dispersing of each component described above at one time or at plural times, and heating if necessary, the electrically conductive adhesive composition according to the embodiment is obtained as a paste-like composition in which each component is evenly dispersed. Examples of a device for dispersing and dissolving used at this time include a well-known stirrer, a Raikai mixer, a triple roller, a planetary mixer, or the like.

According to the electrically conductive adhesive composition of the embodiment described above, it is possible to have excellent conductivity and to achieve both the predetermined adhesiveness and conductivity even after the high temperature and high humidity test (85°C/85%). Further, the electrically conductive adhesive composition of the embodiment is used for electrical connection of the electrodes of the solar battery cells and the wiring members, and can apply the excellent connection property regardless of the temperature rising rate at the time of performing the heating step.

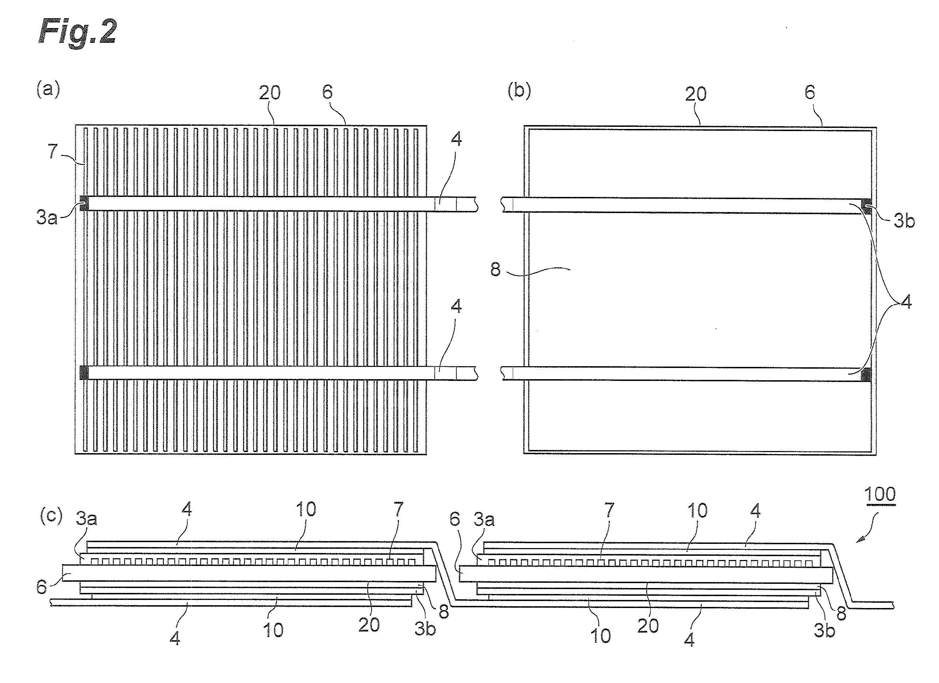

Next, an example of the solar cell module produced using the electrically conductive adhesive composition of the embodiment will be described using Fig. 2.

Fig. 2 is a schematic view showing main parts of the solar cell module, and shows an outline of a structure in which the plurality of solar battery cells are connected to each other by wires. Fig. 2(a) shows a front surface side of the solar battery cell, Fig. 2(b) shows a rear surface (surface on the opposite side to the light-receiving surface), and Fig. 2(c) shows a side surface side.

As shown in Figs. 2(a) to 2(c), in a solar cell module 100, a plurality of solar battery cells 20 in which each of, a grid electrode 7 and a bus electrode (surface electrode) 3a are formed on a front surface side of a semiconductor wafer 6, and a rear surface electrode 8 and a bus electrode (surface electrode) 3b are formed on a rear surface side thereof, are connected to each other by wiring members 4. One end and the other end of the wiring member 4 are connected to the bus electrode 3a of the surface of the solar battery cell and the bus electrode 3b respectively, in series, via the electrically conductive adhesive composition 10 of the embodiment.

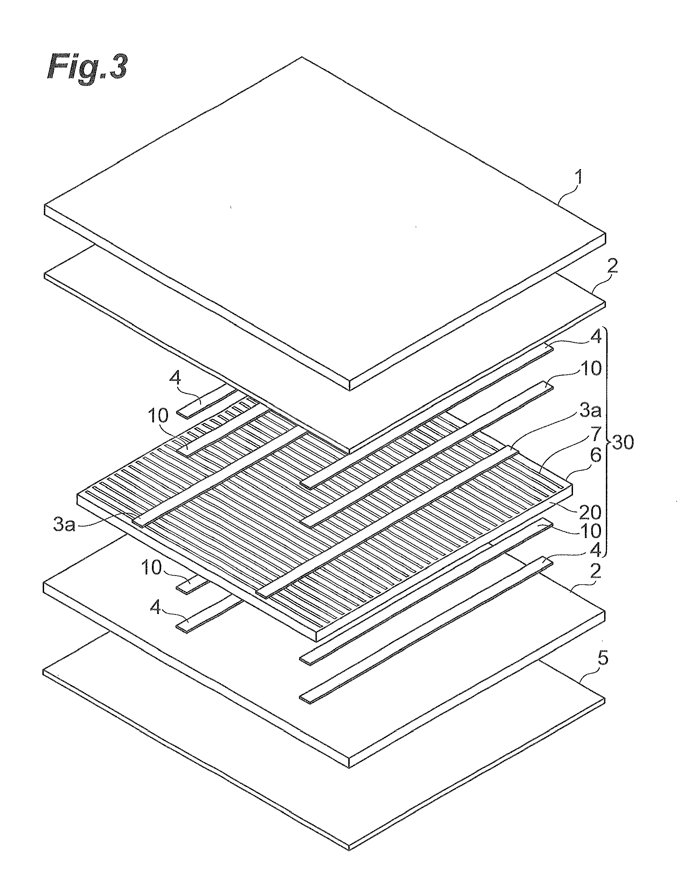

Fig. 3 is a view for illustrating one embodiment of a method for producing the solar cell module of the embodiment.

For example, the solar cell module of the embodiment is manufactured by a production method including: a step of disposing the wiring members 4 and the bus electrodes 3a and 3b so as to face to each other via the electrically conductive adhesive composition 10 to produce a connected body 30; a step of laminating the sealing member 2 onto both surfaces of the connected body 30; a step of laminating a light transmission member 1 on the sealing member 2 on a light-receiving surface side of the solar battery cell 20, and a back sheet 5 (protection film) on the sealing member 2 on a rear surface side of the solar battery cell 20, and a step of performing heating pressure bonding of the obtained laminated body with pressure of 0.1 to 0.3 MPa at a temperature of 140 to 220°C (preferably at a temperature equal to or higher than the melting point of the metal of the electrically conductive particles (A)) for 1 to 30 minutes. In addition, at that time, as the time to reach the set temperature, for example, the time to reach 140°C is preferably 1 minute to 12 minutes from a viewpoint of the heat resistance of the sealing member. In this step of heating pressure bonding, the electric connection and the adhering by the curing of the thermosetting resin between the bus electrodes 3a and 3b of the solar battery cells 20 and the wiring members 4 are performed, and at the same time, the sealing of the solar battery cells 20 is performed, and thus, the solar cell module can be collectively manufactured.

As a method of interposing the electrically conductive adhesive composition 10 between the bus electrode 3a or 3b and the wiring member 4, a method of applying the electrically conductive adhesive composition 10 on the bus electrodes 3a and 3b or the wiring member 4 by a dispensing method, a screen printing method, and a stamping method, is used, for example. After that, by disposing the wiring member 4 and the bus electrodes 3a and 3b so as to face to each other via the electrically conductive adhesive composition 10, the connected body 30 can be obtained.

Other than these manufacturing method, after disposing the wiring member 4 and the bus electrodes 3a and 3b of the solar battery cells 20 so as to face to each other via the electrically conductive adhesive composition 10, preliminary pressure bonding in which the electrical connection of the bus electrodes 3a and 3b of the solar battery cells 20 and the wiring members 4 is conducted by performing heating pressure bonding with pressure of 0.1 to 6.0 MPa at a temperature of 140 to 210°C (preferably a temperature equal to or higher than the melting point of the electrically conductive particles (A)) for 1 to 30 minutes, may be performed. By performing the preliminary pressure bonding, since the connection of the solar battery cells 20 and the wiring members 4 is performed, it is easy to handle the connected body 30 and the workability at the time of manufacturing the solar cell module is improved.

In a case of performing the preliminary pressure bonding, the sealing members 2 are disposed on both surfaces of the obtained connected body 30, the light transmission member 1 is disposed on the sealing member 2 on a light-receiving surface of the solar battery cell 20 side, a back sheet 5 (protection film) is disposed on the sealing member 2 on a rear surface side of the solar battery cell 20, the obtained laminated body is subject to heating pressure bonding with pressure of 0.1 to 6 MPa at a temperature of 140 to 180°C for 1 to 30 minutes to seal the solar battery cells 20, and thus, the solar cell module can be produced.

A glass plate can be used as the light transmission member 1. Examples of the glass plate include dimpled whiteboard-reinforced glass for solar battery cells. Examples of the sealing member 2 include ethylene-vinyl acetate copolymer resins (EVA) or sealing resins using polyvinylbutyral. Examples of the wiring members 4 include TAB lines obtained by performing dipping or plating of solder to a Cu line. Examples of the back sheet 5 include PET-based or Tedlar-PET laminated material, metal foil-PET laminated material.

Even in a case of using the film-like circuit substrate in which a metal wire is formed on a plastic substrate, the electrically conductive adhesive composition of the embodiment can perform connection with the electrodes of the solar battery cells in the steps described above.

In addition, the electrically conductive adhesive composition of the embodiment can also be used for the connection of the electrodes of the rear surface electrode-type (back contact-type) solar battery cells and the wiring members. In this case, first, the electrically conductive adhesive composition of the embodiment is applied onto the electrodes of the circuit substrates or onto the rear surface electrodes of the solar battery cells. Then, the sealing member obtained by gouging the electrode portion (applied portion of the electrically conductive adhesive composition) of the circuit substrate out is laminated on the circuit substrate, the solar battery cells are disposed thereon so that the rear surface electrodes of the solar battery cells and the electrode portions of the circuit substrates are connected to each other via the electrically conductive adhesive composition. Further, the sealing members and the light transmission member are disposed on the light-receiving surfaces of the solar battery cells, the back sheets are disposed on the rear surface side of the solar battery cells, and heating pressure bonding of this solar cell module is performed, and thus, connecting and adhering of the rear surface electrodes of the solar battery cells and the electrodes of the circuit substrates, and the sealing step of the solar battery cells can be collectively performed. As the glass and sealing members, the examples used in the method for producing the solar cell module can be used.

### Examples

Hereinafter, the present invention will be described in more detail with Examples, however, the present invention is not limited to Examples. In addition, the materials used in Examples and Comparative Examples are manufactured in the method described below or purchased.

### [Example 1]

25.2 parts by mass of YL980 (product name of bisphenol A-type epoxy resin, manufactured by Mitsubishi Chemical Corporation), 1.3 parts by mass of 2PHZ-PW (product name of 2-phenyl-4-methyl-5-hidroxymethylimidazole, manufactured by Shikoku Chemicals Corporation), and 3.5 parts by mass of BHPA (2,2-bis(hydroxymethyl)propionic acid) were mixed to each other, and were passed through a triple roller three times, to produce an adhesive component.

Then, 70 parts by mass of Sn42-Bi58 particles (average particle size of 20 µm, melting point: 138°C) which are electrically conductive particles were added with respect to 30 parts by mass of the adhesive component described above, stirring thereof was performed using a planetary mixer, and a defoaming process was performed at equal to or less than 500 Pa for 10 minutes, and thus, an electrically conductive adhesive composition was obtained.

### [Examples 2 to 6 and Comparative Examples 1 to 5]

As described above, electrically conductive adhesive compositions of Examples 2 to 6 and Comparative Examples 1 to 5 were obtained in the same manner as Example 1 except for composition shown in Tables 1 and 2. Further, the unit of the combination rates of each material in Tables 1 and 2 is parts by mass.
YDF-070: bisphenol F-type epoxy resin manufactured by Tohto Kasei Co., Ltd.
Sn42-Bi57-Ag1 solder: manufactured by Mitsui Mining & Smelting Co., Ltd., melting point of 139°C
Sn96.5-Ag3-Cu0.5 solder: manufactured by Mitsui Mining & Smelting Co., Ltd., melting point of 217°C
Sn99.3-Cu0.7 solder: 227°C
2PZ-CN: 1-cyanoethyl-2-phenylimidazole manufactured by Shikoku Chemicals Corporation
2MAOK-PW:2,4-diamino-6-[2'-methylimidazolyl-(1')]-ethyl-s-triazine isocyanuric acid adduct manufactured by Shikoku Chemicals Corporation
C11Z-CN: 1-cyanoethyl-2-undecylimidazole manufactured by Shikoku Chemicals Corporation
2P4MHZ-PW: 2-phenyl-4-methyl-5-hydroxymethylimidazole manufactured by Shikoku Chemicals Corporation
2MZ-H: 2-methylimidazole manufactured by Shikoku Chemicals Corporation
2PZ: 2-phenylimidazole manufactured by Shikoku Chemicals Corporation
2P4MZ: 2-phenyl-4-methylimidazole manufactured by Shikoku Chemicals Corporation

The reaction start temperatures of the thermosetting resins and the curing catalysts according to Examples 1 to 6 and Comparative Examples 1 to 5 were measured by the following method and the results thereof were shown in Tables 1 and 2.

### [Measurement of Reaction Start Temperatures]

25.2 parts by mass of thermosetting resins and 1.3 parts by mass of curing catalysts according to Examples 1 to 6 and Comparative Examples 1 to 5 were mixed, and were passed through a triple roller three times, to produce compositions for reaction start temperature measurement. The obtained compositions for reaction start temperature measurement were weighed to have 2.0 mg in a sample container of the Differential Scanning Calorimetry (DSC), the curing exothermic behaviors obtained by the DSC measurement were shown in the drawings, and the reaction start temperature were obtained. In the DSC measurement, using a DSC (Pyris1 DSC) manufactured by Perkin Elmer Inc., temperature rising in an enclosed container under a nitrogen atmosphere at a temperature rising rate of 10°C/min from 30°C to 250°C was measured. A rising temperature of the curing exothermic peak (DSC Onset temperature) is acquired from the obtained DSC chart, and this is set as the reaction start temperature.

The characteristics of the electrically conductive adhesive compositions according to Examples 1 to 6 and Comparative Examples 1 to 5 were measured by the following method. The results thereof are shown in Tables 1 and 2.

The obtained electrically conductive adhesive compositions were printed onto the surface electrodes (material: silver glass paste, 2 mm x 125 mm) formed on the light-receiving surfaces of the solar battery cells (125 mm x 125 mm, thickness of 210 µm) by using a metal mask (thickness of 100 µm, opening dimension of 1.2 mm x 125 mm), and solder-coated tab line ("A-TPS", product name, manufactured by Hitachi Cable, Ltd.) was disposed onto the printed electrically conductive adhesive composition as the wiring members. The same process was performed for the electrodes on the rear surface of the solar battery cells, and the solder-coated tab line was disposed. After that, a sealing resin (SOLAR EVA SC50B produce name manufactured by Mitsui Chemicals Fabro, Inc.) and a protection film (KOBATECH PV: product name, manufactured by Kobayashi & Co., Ltd.) were laminated onto the rear surface of the solar battery cell, and the sealing resin (SOLAR EVA SC50B produce name manufactured by Mitsui Chemicals Fabro, Inc.) and glass (200 x 200 x 3 mm) were laminated onto the light-receiving surface of the solar battery cell. The obtained laminated body was mounted on a heat plate side of a vacuum laminator (LM-50X50-S product name, manufactured by NPC Incorporated) so as to come in contact with the glass and left for 5 minutes under reduced pressure of 0.1 MPa, and then, the laminated body was heated at 140°C for 10 minutes in a state where the vacuum state of the vacuum laminator is released, to produce a solar cell module. At that time, the time to reach 140°C was 8 minutes.

### [Metal Fusion State Evaluation]

The fusion state of the metal in the electrically conductive adhesive composition between the surface electrodes of the solar cell module obtained in the steps described above and the wiring members was observed by an X-ray inspection system (SMX-1000, micro focus X-ray inspection system manufactured by Shimadzu Corporation). The evaluation was performed by setting a state where the electrically conductive particles were fused as A, a state where a part of non-fused particles exists as B, and a state where the electrically conductive particles were not fused as C. The results thereof are shown in Tables 1 and 2.

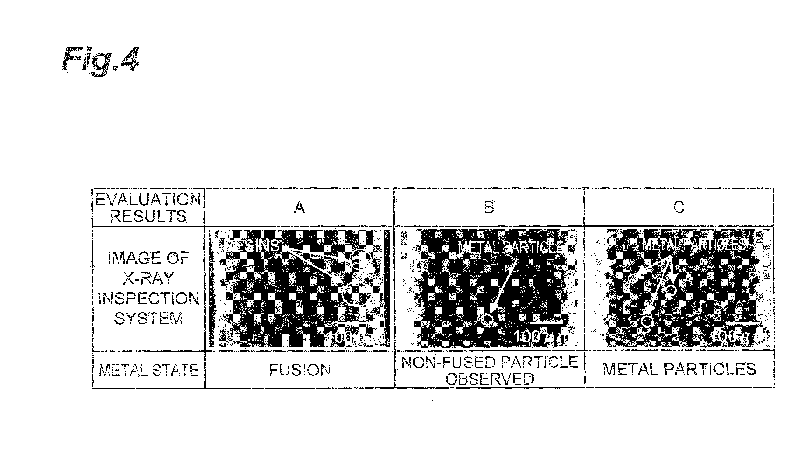

Fig. 4 is a view showing pictures captured by the X-ray inspection system regarding the evaluation results as the respective states A, B, and C. In the state where the electrically conductive particles were not fused (non-fusion), black granular metal particles were observed in the picture captured by the X-ray inspection system as shown in C of Fig. 4. In addition, in the state where the electrically conductive particles were fused, as shown in A of Fig. 4, the black granular metal particles seen at the time of non fusion were not observed, and a bulk metal fused body obtained by the fusion of the electrically conductive particles was seen as black shadow of one surface.

### [High Temperature and High Humidity Test]

An IV curve of the obtained solar cell module was measured using a solar simulator (WXS-155S-10: product name, manufactured by Wacom Electric Co., Ltd., AM: 1.5G). In addition, after leaving the solar cell module under an atmosphere with a high temperature and high humidity of 85°C and 85%RH for 1500 hours, the IV curve was measured in the same manner. Fill factors (hereinafter, abbreviated as F.F) which show electrical properties of the solar battery were derived from each IV curve, respectively, the change rate of F.F before leaving under the atmosphere with a high temperature and high humidity and F.F after leaving it under the atmosphere with a high temperature and high humidity [F.F (1500h)* 100 / F.F (0h)] was set to ΔF.F, and this was used as an evaluation index. In addition, generally, if the value of ΔF.F is equal to or more than 95%, it is determined that the connection reliability is excellent. The obtained results are shown in Tables 1 and 2.

### [Metal Fusion State Evaluation with Change of Time to Reach 140°C]

In the same steps described above, the time to reach 140°C at the time of heating by the vacuum laminator was changed to 10 minutes and 12 minutes, the fusion states of the metal in the electrically conductive adhesive composition between the surface electrodes of the obtained solar cell module and the wiring members were observed by the X-ray inspection system (SMX-1000, micro focus X-ray inspection system manufactured by Shimadzu Corporation). The evaluation of the metal fusion state was performed by the same method as described above. The results thereof are shown in Tables 1 and 2.

**[Table 1]**

| Items | | Example 1 | Example 2 | Example 3 | Example 4 | Example 5 | Example 6 |
|---|---|---|---|---|---|---|---|
| Thermosetting resins | YL980 | 25.2 | 25.2 | 25.2 | 25.2 | - | 25.2 |
| | YDF-170 | - | - | - | - | 25.2 | - |
| Curing catalysts | 2PHZ-PW | 1.3 | - | - | - | - | 0.65 |
| | 2PZ-CN | - | 1.3 | - | - | - | - |
| | 2MAOK-PW | - | - | 1.3 | - | - | - |
| | C11Z-CN | - | - | - | 1.3 | - | - |
| | 2P4MHZ-PW | - | - | - | - | 1.3 | 0.65 |
| | 2MZ-H | - | - | - | - | - | - |
| | 2PZ | - | - | - | - | - | - |
| | 2P4MZ | - | - | - | - | - | - |
| Flux activator | BHPA | 1.5 | 1.5 | 1.5 | 1.5 | 1.5 | 1.5 |
| Electrically conductive particles | Sn42-Bi58 | 70 | 70 | 70 | 70 | - | 70 |
| | Sn42-Bi57-Ag1 | - | - | - | - | 70 | - |
| | Sn99.3-Cu0.7 | - | - | - | - | - | - |
| Reaction start temperatures (°C) | | 174 | 148 | 140 | 144 | 150 | 154 |
| Time to reach 140°C 8 minutes | Metal fusion state evaluation | A | A | A | A | A | A |
| | ΔF.F (%) | 98.9 | 96.5 | 98.1 | 98.3 | 97.6 | 98.0 |
| Time to reach 140°C 10 minutes | Metal fusion state evaluation | A | A | A | A | A | A |
| Time to reach 140°C 12 minutes | Metal fusion state evaluation | A | B | B | B | B | A |

**[Table 2]**

| Items | | Comp. Example 1 | Comp. Example 2 | Comp. Example 3 | Comp. Example 4 | Comp. Example 5 |
|---|---|---|---|---|---|---|
| Thermosetting resins | YL980 | 25.2 | 25.2 | 25.2 | 26.5 | 25.2 |
| | YDF-170 | - | - | - | - | - |
| Curing catalysts | 2PHZ-PW | - | - | 1.3 | - | - |
| | 2PZ-CN | - | - | - | - | - |
| | 2MAOK-PW | - | - | - | - | - |
| | C11Z-CN | - | - | - | - | - |
| | 2P4MHZ-PW | - | - | - | - | - |
| | 2MZ-H | 1.3 | - | - | - | - |
| | 2PZ | - | 1.3 | - | - | - |
| | 2P4-MZ | - | - | - | - | 1.3 |
| Flux activator | BHPA | 1.5 | 1.5 | 1.5 | 1.5 | 1.5 |
| Electrically conductive particles | Sn42-Bi58 | 70 | 70 | | 70 | 70 |
| | Sn42-Bi57-Ag1 | - | - | - | - | - |
| | Sn99.3-Cu0.7 | - | - | 70 | - | - |
| Reaction start temperatures (°C) | | 95 | 100 | 174 | - | 125 |
| Time to reach 140°C 8 minutes | Metal fusion state evaluation | B | B | C | C | B |
| | ΔF.F (%) | 89.8 | 91.2 | 83.4 | 84.0 | 89.6 |
| Time to reach 140°C 10 minutes | Metal fusion state evaluation | C | C | C | C | C |
| Time to reach 140°C 12 minutes | Metal fusion state evaluation | C | C | C | C | C |

All of the electrically conductive adhesive compositions of Examples 1 to 6 showed excellent metal fusion state and ΔF.F (%). On the other hand, in Comparative Examples 1 to 5, a part of the metal particles is not fused or metal particles were not fused, and since ΔF.F (%) is decreased, the problem in the connection property could be checked.

Meanwhile, as described above, at the time of producing the solar cell module, there is a step of applying the electrically conductive adhesive composition onto the electrodes of the solar battery cells, a step of disposing the electrodes onto which the electrically conductive adhesive composition is applied and the wiring member so as to face to each other, a step of laminating the sealing member and the light transmission member in this order onto the light-receiving surface of the solar battery cell, a step of laminating the sealing member and the protection member in this order onto the surfaces on the opposite side to the light-receiving surface of the solar battery cell, and a step of heating the obtained laminated body using the vacuum laminator or the like. At the time of this heating, since the heat capacity is increased with the size-enlargement of the solar cell module, the time to reach the set temperature tends to be delayed.

Even in the cases where the time to reach 140°C of all of the electrically conductive adhesive composition of Examples 1 to 6 were delayed to 10 minutes and 12 minutes, the metal particles were sufficiently fused and excellent connection property was shown. However, in the cases where the time to reach 140°C of all of the electrically conductive adhesive composition of Comparative Examples 1 to 5 were delayed to 10 minutes and 12 minutes, the fusion of the metal did not occur, and the problem in the connection property occurred. It is presumed that, since the curing of the thermosetting resin proceeds before the occurrence of fusion of the metal of the electrically conductive particles, the fusion of the electrically conductive particles was disturbed and the connection property is degraded.

Thus, according to the present invention, it is possible to provide an electrically conductive adhesive which has excellent conductivity, sufficiently suppresses decrease of the conductivity even after the high temperature and high humidity test (85°C/85%), and has excellent conductivity even in a case where the time to reach the set temperature is delayed, in a case of being used for the connection of the electrodes of the solar battery cells and the wiring member.

### Reference Signs List

1: Light transmission member, 2: Sealing member, 3a, 3b: Bus electrodes (surface electrodes), 4: Wiring members, 5: Back sheet, 6: Semiconductor wafer, 7: Grid electrode, 8... Rear surface electrode, 10: Electrically conductive adhesive composition, 20: Solar battery cell, 30: Connected body, 100: Solar cell module

## Claims

1. An electrically conductive adhesive composition comprising:
electrically conductive particles (A) containing metal having a melting point of equal to or lower than 220°C;
a thermosetting resin (B);
a flux activator (C); and
a curing catalyst (D),
wherein a reaction start temperature of the thermosetting resin (B) and the curing catalyst (D) is 130 to 200°C.

2. The electrically conductive adhesive composition according to claim 1, wherein the metal of the electrically conductive particles (A) contains at least one component selected from a group consisting of bismuth, indium, tin, and zinc.

3. The electrically conductive adhesive composition according to claim 1 or 2, wherein the thermosetting resin (B) contains an epoxy resin.

4. The electrically conductive adhesive composition according to any one of claims 1 to 3, wherein the flux activator (C) contains a compound having a hydroxy group and a carboxyl group in a molecule.

5. The electrically conductive adhesive composition according to any one of claims 1 to 4, being used for electrical connection of the electrodes of solar battery cells and a wiring member.

6. A connected body in which a plurality of solar battery cells are connected via a wiring member,
wherein electrodes of the solar battery cells and the wiring member are connected via the electrically conductive adhesive composition according to any one of claims 1 to 5.

7. A method for producing a solar cell module comprising:
a step of applying the electrically conductive adhesive composition according to any one of claims 1 to 5 onto electrodes of solar battery cells;
a step of disposing the electrodes onto which the electrically conductive adhesive composition is applied and a wiring member so as to face to each other;
a step of laminating a sealing member and a light transmission member in this order onto a light-receiving surface of the solar battery cell;
a step of laminating a sealing member and a protection member in this order onto a surface on an opposite side to the light-receiving surface of the solar battery cell; and
a step of sealing the solar battery cells while electrically connecting and adhering the solar battery cells and the wiring members by heating the obtained laminated body.

8. A solar cell module in which electrodes of a plurality of solar battery cells and wiring members are electrically connected to each other via the electrically conductive adhesive composition according to any one of claims 1 to 5.
